Europäisches Patentamt

European Patent Office

Office européen des brevets

(11) Publication number: **0 024 957**
**B1**

(12) **EUROPEAN PATENT SPECIFICATION**

(45) Date of publication of patent specification: **12.10.83**

(21) Application number: **80400871.2**

(22) Date of filing: **13.06.80**

(51) Int. Cl.³: **G 01 D 5/245,**
**H 03 K 21/00**

(54) Apparatus for determining the position of an object.

(30) Priority: **31.08.79 US 71622**

(43) Date of publication of application:
**11.03.81 Bulletin 81/10**

(45) Publication of the grant of the patent:
**12.10.83 Bulletin 83/41**

(84) Designated Contracting States:
**CH DE FR GB IT LI SE**

(73) Proprietor: **THE BENDIX CORPORATION**
**Executive Offices Bendix Center**
**Southfield Michigan 48037 (US)**

(72) Inventor: **Tumbush, Gerald Lawrence**
**1867 Hickory Ridge Drive**
**Dayton, Ohio 45432 (US)**

(74) Representative: **Maguet, André et al,**
**Service Brevets Bendix 44, Rue François 1er**
**F-75008 Paris (FR)**

(56) References cited:
**US - A - 3 749 890**

**HEWLETT-PACKARD JOURNAL, vol. 30, no. 1,**
**January 1979, pages 2—11**
**Palo Alto, Cal,. U.S.A.**
**L. W. MASTERS et al.: "A low-cost,**
**microprocessor-based, 100-MHz universal**
**counter"**

(56) References cited:
**IEEE TRANSACTIONS ON INSTRUMENTATION**
**AND MEASUREMENT, vol. IM-22, no. 3,**
**September 1973, pages 226—230**
**New York, U.S.A.**
**P. RAMACHANDRAN: "A new technique for**
**designing high-speed frequency counters"**

**INSTRUMENTS AND EXPERIMENTAL**
**TECHNIQUES, November/December 1966,**
**pages 1397—1401**
**New York, U.S.A.**
**M. N. IVANOV et al.: "Multi-input counting**
**system with information output"**

## Apparatus for determining the position of an object

This invention relates to an apparatus for determining the position of an object having means coupled to the object for producing digital pulses representative of the position of the object, and means for receiving and counting these pulses including a hardware-type counter. More particularly, the present invention is specifically related to coordinate measuring machines of the type wherein a displacement of a probe or other measuring instrument creates a series of pulses which are detected and counted as an indication of displacement.

An application of this apparatus has been suggested in European published application No. 0 025 724 entitled "Method of making measurements on an object by means of a moveable probe" which relates to both multidimensional and single-dimensional measuring.

The number of pulses created is related to the amount of displacement and the resolution of the measuring system. The rate at which the pulses are generated is a function of the speed of movement of the probe as well as the previously mentioned factors. In such a measuring system, the apparatus should not lose pulses, should have a high resolution for accurate readings and be capable of an operating speed of the probe which is not limiting on the operator. In other words, the probe and measuring system should be capable of reading the highest reasonable speed at which an operator can move the probe. Such speed is desirable so that the operator can make measurements as quickly as possible.

These constraints combine to require an apparatus which is responsive to a large magnitude of pulse counts which may occur randomly and which may occur rather close together in time. Accuracy of the counts is essential to the operation. The prior art includes measuring machines which have hardware counters which are responsive to rapidly occurring pulse counts. These counters are binary generally, and as such require a significant number of digits to record the number of pulses which might be generated by a typical machine (perhaps the 20th or 24th power of 2). The hardware to use such counters is extremely large, cumbersome and costly both in terms of size and complexity of programming and interconnection.

In theory, it would be possible to provide a programmed general purpose computer to provide the count processing from a coordinate measuring machine. However, the frequent and random generation of counts would require a very cumbersome process of interrupts of the computer everytime a pulse is received. Therefore, such a system is not preferred.

An apparatus for determining the position of an object including a hardware-type counter has been proposed in U.S. Patent 3 749 890.

The article entitled "A low-cost microprocessor-based, 100-MHz universal counter" Hewlett-Packard Journal, Vol. 30, no. 1, January 1979, pages 2—11, Palo Alto, Cal., U.S.A. discloses a microprocessor-based general purpose counter with the following configuration: a data-acquisition block comprising a hardware type counter for receiving and counting digital pulses representative of the measurements under consideration; a computation and control block coupled to the hardware-type counter and being adapted to periodically read the hardware-type counter and to update a RAM memory content, which after being properly processed, will be displayed; and an output block comprising a display coupled to the micro-processor RAM memory for periodically displaying data stored in said micro-processor memory.

Other counting systems have been described in the article entitled "Multi-input counting system with information output", Instruments and experimental techniques, November/December 1966, pages 1397—1401, New York U.S.A.

This invention proposes an apparatus for determining the position of an object having means coupled to the object for producing digital pulses representative of the position of the object, and means for receiving and counting the pulses including hardware-type counters one for each respective direction of movement, a computer including a stored program and a count storage location, said computer being coupled to the hardware-type counters and being adapted to repetitively read the hardware-type counters and update the count storage location by adding an amount based upon the periodic reading of the hardware-type counters; and a display coupled to the count storage location for periodically displaying a representation thereof as an indication of the position of the object, characterized in that each of said hardware-type counters has a count capacity less than the count capacity necessary for the maximum expected count and in that the reading and updating is made on a periodic basis, the period being chosen to be shorter than the time necessary for said hardware-type counters to accumulate counts totalling their capacity by means of an interval timer controlling the reading of said counters by the computer according to said periodic basis.

It will be understood that with such an arrangement it is possible to use more smaller hardware counters than the ultimate dimensional measurement which results in hardware simplicity and economy in design.

According to another feature of the invention, the periodic basis is so chosen that the update of the count storage location is based upon the difference between the present value and the preceding value of the hardware-type counters.

This feature avoids resetting of the hardware counters upon reading and allows a more accurate count and measurement, without loosing pulses occuring about the time of the reset.

The apparatus of the invention allows high measurement resolution without requiring a very large hardware-type counters, while having the capability of responding to randomly-occuring count pulses, even if the pulses occur simultaneously in each of two or more axes of measurement.

The apparatus of the invention allows the accumulation of measurement information in the form of count pulses accumulated in a hardware storage member (counter) associated with each of the measurement axes without requiring a computer interrupt (or any access to the computer at all) as a result of either a single pulse count or any accumulation of count pulses (as, for example, if the counter were to produce overflow signals). Accordingly, the counters of the present invention which receive the pulses are merely read periodically to provide updating information to the second set of counters which are preferably contained in memory associated with a central processor of the micro-processor type.

The manner of carrying out the invention is described in detail below with reference to the accompanying drawings which illustrate one specific embodiment, in which:

FIGURE 1 is a block diagram of a measuring machine including the counting system of the present invention; and

FIGURE 2 is an expanded view of a processor used in the present invention, together with parts of its environment.

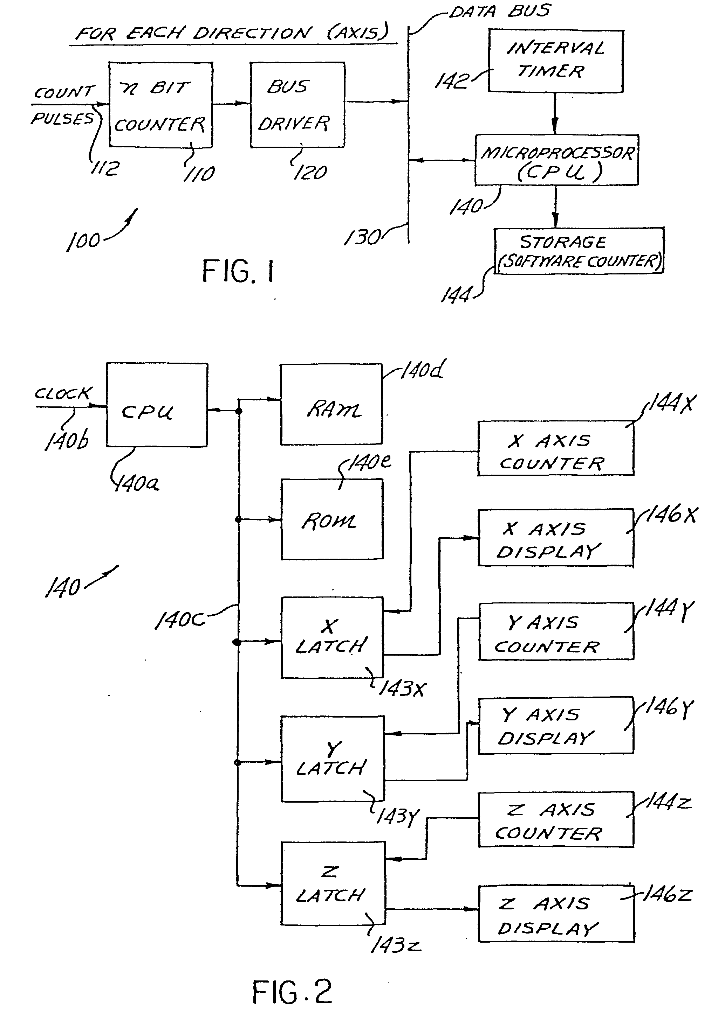

FIGURE 1 shows a block diagram representation of a counting apparatus 100 for a single direction for a measuring machine. The counting apparatus 100 includes an n bit hardware counter 110 coupled to receive count pulses on a line 112. The counter 110 is coupled to a bus driver 120 which in turn is coupled to a data bus 130. The data bus 130 is coupled to a micro-processor (central processor) 140. The micro-processor 140 is coupled to an interval timer 142 and has storage locations 144 associated to it. The counter 110 is a hardware type counter and is commercially available. While the n bits are more than the number of count pulses which can be reasonably expected in an interval, the n bits in the counter 110 are less than the ultimate count which might be anticipated in the direction of measurement. The interval timer 142 periodically initiates a reading of the n bit counter 110 through the bus driver 120 and data bus 130. At such intervals, the reading of the b bit counter 110 is transferred to the micro-processor 140. While the n bit counter might be reset after each measurement, a more prudent approach is to have the n bit counter free running and not reset and to merely read the counter, determine the difference from the last reading and use a difference as an adjustment to the count already in the storage. In this manner, counts cannot become lost by being created during the reading of the counter.

FIGURE 2 shows the micro-processor 140 in greater detail. The micro-processor 140 includes a central processing unit (CPU) 140a. The CPU 140a is driven by a clock input 140b and includes a data bus 140c. The data bus 140c couples the central processing unit (CPU) 140a to a random access memory (RAM) 140d and a read only memory (ROM) 140e. The memories 140d, 140e have the stored program for the central processing unit 140a, including the instructions and other information necessary to make the calculations and conversions required for the measurements.

The data bus 140c is also coupled to three latches, one for each direction of measurement. These latches are designated generally by the referenced numerals 143X, 143Y, 143Z. Each of the latches is coupled to its respective hardware counter and a display. Thus, the latch 143X is coupled to an X axis counter 144X and to an X axis display 146X. The Y latch 143Y is coupled to a Y axis counter 144Y and a Y axis display 146Y. The Z latch 143Z is coupled to a Z axis counter 144Z and a Z axis display 146Z.

Advantageously, each of the latches 143X, 143Y, 143Z contains a pair of latching elements. The one latching element associated with each latch is coupled to the display and the other is coupled to and associated with the hardware counter. In such a manner, the CPU 140a can access each of the six latching elements separately, to obtain information from each of the counters individually and to provide output information to each display separately.

The CPU 140a is driven by the interval timer 142 to periodically read the information from the counters 144X, 144Y, 144Z to update the internal or software storage associated with the micro-processor. The interval chosen is to some extend arbitrarily chosen to be 1 or 2 milliseconds in some applications. This interval is chosen to be less than the capacity of the counters to accumulate measurement pulses in the hardware counters.

In addition to the CPU 140a being responsive to a measurement of time by the interval timer 142, the CPU 140a may be responsive to the occurence of an external signal, such as an electric signal indicative of contact between a touch probe and an object being inspected. In such a case, the CPU 140a obtains current information from the hardware counters essentially simultaneousl;y to determine the position of the probe at the instant (and therefore location) of contact. The counters are sequentially read and processed by the CPU 140a to provide updating information for the second or software-type set of counters associated with each of the axes of movement or degrees of freedom.

The type of information stored in each of the counters is subject to some choice. The generally preferred method is believed to have the counters of the hardware-type be free-running up/down counters which are not reset after each reading. In such a case, each reading of the hardware counters requires that the present reading have the preceding reading substracted from it to obtain the number (and direction) of measurement pulses occuring in the time interval between readings, in the given direction. The number of pulses (with an appropriate sign to indicate direction)· are then used to update the count in that direction presently stored in a memory location serving as a second or software counter or storage.

The source of the measurement pulses being counted may be from any of a number of known sources of measurement indicative pulses.

Many modifications of the present invention will be apparent to those skilled in the art. For examples, the latches are optional and most desirable in conjunction with a touch probe for a measuring machine. In a layout machine, such latches may be eliminated.

## Claims

1. Apparatus for determining the position of an object having means coupled to the object for producing digital pulses representative of the position of the object, and means for receiving and counting the pulses including hardware-type counters (110) one for each respective direction of movement, a computer (140) including a stored program and a count storage location (144), said computer (140) being coupled to the hardware-type counters (110) and being adapted to repetitively read the hardware-type counters (110) and update the count storage location (144) by adding an amount based upon the periodic reading of the hardware-type counters (110); and a display coupled to the count storage location (144) for periodically displaying a representation thereof as an indication of the position of the object, characterized in that each of said hardware-type counters (110) has a count capacity less than the count capacity necessary for the maximum expected count and in that the reading and updating is made on a periodic basis, the period being chosen to be shorter than the time necessary for said hardware-type counters (110) to accumulate counts totalling their capacity by means of an interval timer (142) controlling the reading of said counters (110) by the computer (140) according to said periodic basis.

2. Apparatus according to Claim 1, characterized in that the hardware-type counters are free-running up/down counters not reset after each reading so that the update of the count storage location (144) is based upon the difference between the present value and the preceding value of the hardware-type counters (110).

## Revendications

1. Un appareil pour déterminer la position d'un objet, ayant des moyens couplés à l'objet pour produire des impulsions numériques représentatives de la position de l'objet et des moyens pour recevoir et compter les impulsions, comprenant des compteurs (110) du type matériel, un pour chaque direction de déplacement respective, un ordinateur (140) comportant un programme mémorisé et un emplacement (144) de stockage de comptes, ledit ordinateur (140) étant couplé aux compteurs (11) du type matériel et étant conçu pour lire de manière répétitive les compteurs (11) du type matériel et mettre à jour l'emplacement (144) de stockage de comptes en y ajoutant une quantité basée sur la lecture périodique des compteurs (110) du type matériel; et un dispositif d'affichage couplé à l'emplacement (144) de stockage de comptes pour en afficher périodiquement une représentation en tant qu'indication de la position de l'objet, caractérisé en ce que chacun des compteurs (110) du type matériel a une capacité de comptage inférieure à la capacité de comptage nécessaire pour contenir le compte maximal escompté et en ce que la lecture et la mise à jour sont effectuées sur une base périodique, la période étant choisie plus courte que le temps nécessaire aux compteurs (110) du type matériel pour accumuler des comptes atteignant le total de leur capacité, au moyen d'un compteur (142) d'intervalles de temps commandant la lecture desdits compteurs (110) par l'ordinateur (140) conformément à ladite base périodique.

2. Appareil selon la revendication 1, caractérisé en ce que les compteurs du type matériel sont des compteurs progressifs/régressifs à fonctionnement continu qui ne sont pas remis à zéro après chaque lecture de sorte que la mise à jour de l'emplacement (144) de stockage de comptes est basée sur la différence entre la valeur présente et la valeur précédente des comptes des compteurs (110) du type matériel.

## Patentansprüche

1. Vorrichtung zum Bestimmen der Lage eines Gegenstandes, mit einer mit dem Gegenstand verbundenen Einrichtung zum Erzeugen digitaler Impulse, die die Lage des Gegenstandes darstellen, und einer Einrichtung zum Empfang und Zählen der Impulse, die Hardware-Zähler (110) umfaßt, und zwar jeweils einen für jede Bewegungsrichtung, einem Rechner (140), der ein gespeichertes Programm und eine Speicherzählerstelle (144) umfaßt, wobei der Rechner (140) an den Hardware-Zählern (110) angeschlossen ist und in der Lage ist, die Hardware-Zähler (110) sich wiederholend abzulesen und die Speicherzählerstelle (144) durch Addition eines Betrages, der auf der periodischen Ablesung der Hardware-Zähler (110) basiert, fortzuschreiben, und einer Anzeige, die an der Speicherzählerstelle (144) angeschlossen ist, um eine Darstellung derselben als Anzeige der Lage des Gegenstandes periodisch wiederzugeben, dadurch gekennzeichnet, daß jeder der Hardware-Zähler (110) eine Zählkapazität besitzt, die kleiner ist als die für die zu erwartende maximale Zählung erforderliche Zählkapazität, und daß das Ablesen und Fortschreiben auf periodischer Basis erfolgt, wobei die Periode Kürzer gewählt wird als die Zeit, die für die Hardware-Zähler (110) erforderlich ist, um ihrer Gesamtkapazität entsprechende Zählungen zu sammeln, und zwar mittels eines Intervallzeitgebers (142), der das Ablesen der Hardware-Zähler (110) durch den Rechner (140) auf der besagten periodischen Basis steuert.

2. Vorrichtung nach Anspruch 1, dadurch gekennzeichnet, daß die Hardware-Zähler freilaufende Vorwärts-Rückwärts-Zähler sind, die nach jeder Ablesung nicht zurückgestellt werden, sodaß das Fortschreiben der Speicherzählerstelle (144) auf der Differenz zwischen dem gegenwärtigen Wert und dem vorhergehenden Wert der Hardware-Zähler (110) basiert.

FOR EACH DIRECTION (AXIS)

DATA BUS

COUNT PULSES → [ n BIT COUNTER ] → [ BUS DRIVER ] →

112    110    120

100

[ INTERVAL TIMER ]  142

[ MICROPROCESSOR (CPU) ]  140

130

[ STORAGE (SOFTWARE COUNTER) ]  144

## FIG. 1

CLOCK → [ CPU ]

140b    140a

[ RAM ]  140d

[ ROM ]  140e

140

140C

[ X LATCH ]  143X

[ Y LATCH ]  143Y

[ Z LATCH ]  143z

[ X AXIS COUNTER ]  144X

[ X AXIS DISPLAY ]  146X

[ Y AXIS COUNTER ]  144Y

[ Y AXIS DISPLAY ]  146Y

[ Z AXIS COUNTER ]  144z

[ Z AXIS DISPLAY ]  146Z

## FIG. 2